# FASCICULE DE BREVET EUROPEEN

(11) **EP 3 350 828 B1**
(45) Date de publication et mention de la délivrance du brevet: **30.10.2019**
(21) Numéro de dépôt: 16781505.9
(22) Date de dépôt: 19.09.2016
(51) Int. Cl.: H01L 21/762, C30B 25/18, C30B 33/06, H01S 5/02

(54) **PROCEDE DE TRANSFERT DE PAVES MONOCRISTALLINS**
VERFAHREN ZUR ÜBERTRAGUNG VON MONOKRISTALLINEN PADS
METHOD FOR TRANSFERRING MONOCRYSTALLINE PADS

(30) Priorité: 18.09.2015 FR 1558810
(43) Date de publication de la demande: 25.07.2018
(73) Titulaire: Soitec, 38190 Bernin (FR)
(72) Inventeur: GHYSELEN, Bruno, 38170 Seyssinet-Pariset (FR)
(74) Mandataire: Regimbeau
(86) Numéro de dépôt international: PCT/FR2016/052363
(87) Numéro de publication internationale: WO 2017/046548

(56) Documents cités:
- US-A1- 2010 207 212
- US-A1- 2011 244 613
- US-B1- 6 562 127

## Description

### DOMAINE DE L'INVENTION

L'invention concerne un procédé de transfert adapté pour reconstituer un substrat sous forme d'un réseau de pavés monocristallins sur la surface d'un substrat final.

L'invention concerne également un empilement obtenu par ledit procédé de transfert.

### ARRIERE-PLAN DE L'INVENTION

Un procédé de transfert connu de l'état de la technique, décrit dans le brevet US 6,562,127 B1 et présenté à la figure 1 comprend les étapes :
a. Fournir un substrat intermédiaire 1, le substrat intermédiaire 1 comprenant, sur une de ses faces, des pavés 2 assemblés selon une première face principale 3 au substrat intermédiaire 1, lesdits pavés 2 présentant une surface libre 4 opposée à la première face principale 3, et étant en matériau monocristallin, les pavés 2 comprenant une zone de fragilisation 5, la zone de fragilisation 5 et la surface libre 4 de chaque pavé 2 délimitant une portion de pavé 7 destinée à être transférée sur un substrat final 6 ;
b. Exécuter une étape d'assemblage en mettant en contact la surface libre 4 de chacun des pavés 2 avec le substrat final 6 ;
c. Exécuter un détachement au niveau de la zone de fragilisation 5 de chacun des pavés 2 de manière à transférer la portion de pavé 7 de chacun des pavés 2 sur le substrat final 6.

Le document US2011/0244613 décrit un procédé similaire.

On entend par « pavé », une entité comprenant deux faces principales sensiblement parallèles, les deux faces parallèles dudit pavé 2 étant reliées par une surface latérale. Les deux faces principales du pavé 2 peuvent présenter toutes les formes possibles, régulières ou non.

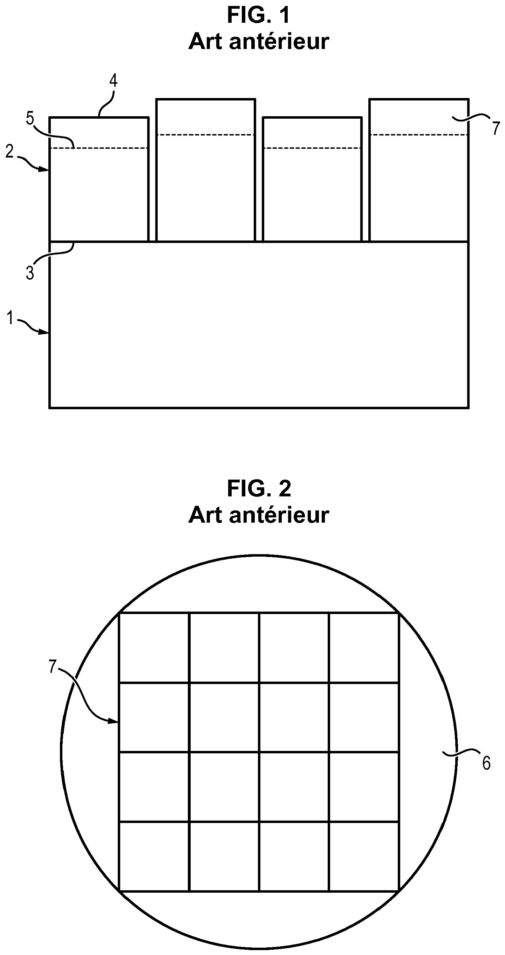

A l'issue du procédé de transfert, les portions de pavés 7 sont reportées sur le substrat final 6 tel que représenté sur la figure 2.

La surface du substrat final 6 est ainsi recouverte de portions de pavés 7 sur lesquelles peuvent être fabriqués des dispositifs pour la microélectronique, la photonique, l'optronique, le photovoltaïque.

Les pavés 2 peuvent comprendre des faces parallèles de forme carrée ou rectangulaire ou hexagonale ou polygonale ou circulaire par exemple, et être disposées de manière régulière, par exemple sous forme d'un quadrillage, sur le substrat intermédiaire 1. Par conséquent, les portions de pavés 7 peuvent également être disposées de manière régulière sur le substrat final 6.

Ce procédé de transfert est particulièrement intéressant lorsque le matériau constituant les pavés 2 ne peut être formé que sous forme de substrats de taille insuffisante (de petit diamètre) au regard de l'application industrielle considérée.

Notamment, les substrats de phosphure d'indium (InP) ne sont disponibles actuellement que sous forme de substrat de 100 mm de diamètre. L'utilisation de tels substrats d'InP dans des lignes existantes de production de circuits sur substrat 200mm est simplement impossible.

Selon le matériau considéré, et au regard de la maturité de l'offre du marché du matériau correspondant, la taille limite évolue. Par exemple pour le silicium, elle est à 300mm.

La liste des matériaux d'intérêt pour faire appel à un tel procédé comprend notamment: le SiC, le GaN, l'InP, le GaSb, le GaP, l'InAs, le Ge, le ZnO, le LiTaO₃, le LiNbO₃, le diamant, le saphir, le MgO, CeO₂, YSZ, SrTiO₃, BaTiO₃, LaAlO₃ par exemple.

Cette liste peut également contenir des matériaux certes disponibles en grand diamètre de manière générale, mais pas selon certaines caractéristiques ou spécifications. Le silicium par exemple est bien disponible aujourd'hui en diamètre 300mm, mais il ne peut pas être obtenu à ce diamètre avec une technique de croissance de lingot de type zone fondue, qui seule autoriserait des teneurs en oxygène résiduelles excessivement faibles.

Un ou plusieurs substrats de petite taille peuvent être découpés en pavés 2.

Les pavés 2 sont alors assemblés à un substrat intermédiaire 1.

Et enfin, les portions de pavés 7, telles que définies dans le procédé décrit dans le brevet US 6,562,127 B1, sont transférées sur un substrat final 6. Le substrat final 6 peut présenter une taille et une forme quelconques.

Ainsi il est possible de transférer des portions de pavés 7 d'un matériau donné sur un substrat circulaire de taille supérieure à 200 mm de diamètre, voire supérieure à 300 mm de diamètre, quelle que soit la taille du substrat à partir duquel sont formés les pavés 2.

Cette technique est d'autant plus intéressante que, pour des raisons de coûts, les fabricants de dispositifs microélectroniques, optroniques, photoniques tentent de plus en plus de fabriquer lesdits dispositifs sur des substrats de taille supérieure à 200 mm de diamètre, voire supérieure à 300 mm de diamètre.

Cependant ce procédé n'est pas satisfaisant.

En effet, pour assurer un assemblage de tous les pavés 2 sur une des faces du substrat final 6, il est nécessaire de procéder à une étape de polissage mécano-chimique ou de polissage double face de manière à rendre coplanaires les surfaces libres des pavés 2.

En effet, les pavés 2 présentent en général des épaisseurs différentes (l'épaisseur d'un pavé 2 étant définie comme la distance entre ses deux faces parallèles).

Tel qu'illustré à la figure 1, les différences d'épaisseurs des pavés 2 assemblés sur un même substrat intermédiaire 1 rendent l'étape d'assemblage par mise en contact de la surface libre 4 de chacun des pavés 2 avec le substrat final 6 impossible, les pavés 2 les moins épais ne pouvant adhérer à la surface du substrat final 6. Par ailleurs, certains pavés 2 ne peuvent venir adhérer que sur une partie de leur surface seulement, la plus épaisse. Toute surépaisseur locale est potentiellement gênante de ce point de vue.

L'étape de planarisation, par polissage mécano-chimique ou de polissage double face, vient pallier ce problème.

Or, l'étape de planarisation affecte inévitablement le rendement du procédé de transfert.

Par ailleurs, l'étape de planarisation peut dégrader la surface libre 4 des pavés 2.

En outre, l'étape de planarisation peut générer un coût additionnel au procédé de transfert, surcoût d'autant plus élevé que le matériau considéré est difficile à polir, à l'image du SiC par exemple.

### OBJET DE L'INVENTION ET BREVE DESCRIPTION DE L'INVENTION

La présente invention vise à pallier ces limitations de l'état de la technique en proposant un procédé de transfert évitant l'emploi d'une étape de planarisation des pavés, ou permettant de simplifier ou d'alléger cette dernière.

L'invention concerne un procédé de transfert comprenant les étapes :
a. Fournir un substrat intermédiaire, le substrat intermédiaire comprenant, sur une de ses faces, des pavés assemblés par une première face principale au substrat intermédiaire, lesdits pavés présentant une surface libre opposée à ladite première face principale, et sont en matériau monocristallin, les pavés comprenant une zone de fragilisation, la zone de fragilisation et la surface libre de chaque pavé, délimitant une portion de pavé destinée à être transférée sur un substrat final ;
b. Exécuter une étape d'assemblage en mettant en contact la surface libre de chacun des pavés avec le substrat final ;
c. Exécuter, après l'étape d'assemblage, un détachement au niveau de la zone de fragilisation de chacun des pavés de manière à transférer la portion de pavé de chacun des pavés sur le substrat final.

Le procédé de transfert est remarquable en ce que lors de l'étape d'assemblage, le substrat intermédiaire se déforme de sorte que les surfaces libres des pavés deviennent coplanaires.

Selon un mode de mise en oeuvre, l'étape b d'assemblage est une étape d'adhésion moléculaire.

Selon un mode de mise en oeuvre, une couche d'assemblage est intercalée entre le substrat final et les pavés avant l'étape b d'assemblage.

Selon un mode de mise en oeuvre, les pavés présentent une épaisseur égale à la distance entre la première face principale et la surface libre dudit pavé, la différence d'épaisseur entre le pavé le plus fin et le pavé le plus épais est inférieure à 50 µm, de préférence inférieure à 5 µm.

Selon un mode de mise en oeuvre, la zone de fragilisation de chacun des pavés est formée par implantation d'espèces ioniques.

Selon un mode de mise en oeuvre, l'étape c. de détachement comprend un traitement thermique.

Selon un mode de mise en oeuvre, le substrat intermédiaire comprend au moins un matériau compris dans la liste : polymère, BCB, PDMS, Polyimides, résines silicone, résines époxy, élastomères, film d'Aluminium, film de Cuivre, film de Molybdène, film de Tungstène, film de Nickel, film d'acier inoxydable, verres, matériaux poly cristallins, matériaux céramiques, matériaux frittés, oxydes, alumines, nitrures, silicates, carbures.

Selon un mode de mise en oeuvre, le substrat intermédiaire comprend une structure comprise dans la liste : structure en grille, structure en tissu, structure en mousse, structure poreuse, matériau composite.

Selon un mode de mise en oeuvre, le substrat intermédiaire est stratifié et comprend au moins une couche additionnelle susceptible de se déformer.

Selon un mode de mise en oeuvre, les pavés comprennent au moins un matériau compris dans la liste : le SiC, le GaN, le GaAs, l'InP, le GaSb, le GaP, l'InAs, le Ge, le ZnO, le LiTaO₃, le LiNbO₃, le diamant, le saphir, le MgO, CeO₂, YSZ, SrTiO₃, BaTiO₃, LaAlO₃, le silicium.

Selon un mode de mise en oeuvre, les pavés comprennent un premier type de pavés et un second type de pavés de nature chimique différente du premier type de pavés.

Selon un mode de mise en oeuvre, la surface libre des pavés présente une forme carrée, rectangulaire, circulaire ou hexagonale.

Selon un mode de mise en oeuvre, le substrat final comprend au moins un matériau compris dans la liste : Si, Ge, GaAs, Saphir, Alumine, verre, quartz, céramiques, plastique, métal, SiC, AIN.

L'invention concerne également, un empilement comprenant :
un premier substrat comprenant, sur une face principale, des pavés assemblés selon une première face principale au premier substrat, ladite face principale du premier substrat étant plane lorsque le premier substrat est à l'état libre, les pavés étant en matériau monocristallin et comprenant une zone de fragilisation,
l'empilement étant remarquable en ce qu'il comprend un second substrat assemblé selon une seconde face principale des pavés opposée à la première face principale desdits pavés, la face principale du premier substrat étant déformée de sorte que les secondes faces principales des pavés sont coplanaires.

Par « état libre » on entend dans le présent texte l'état du premier substrat avant son assemblage au second substrat.

Selon un mode de mise en oeuvre, le second substrat est assemblé à la seconde face des pavés par adhésion moléculaire.

Selon un mode de mise en oeuvre, les pavés présentent une épaisseur égale à la distance entre la première face et la seconde face dudit pavé, la différence d'épaisseur entre le pavé le plus fin et le pavé le plus épais est inférieure à 50 µm, de préférence inférieure à 5 µm.

Selon un mode de mise en oeuvre, les pavés comprennent une zone de fragilisation, la zone de fragilisation et la seconde face de chaque pavé délimitant une portion de pavé destinée à être transférée sur le second substrat, la zone de fragilisation de chacun des pavés étant formée par implantation d'espèces ioniques.

Selon un mode de mise en oeuvre, les pavés comprennent au moins un matériau compris dans la liste : le SiC, le GaN, le GaAs, l'InP, le GaSb, le GaP, l'InAs, le Ge, le ZnO, le LiTaO₃, le LiNbO3, le diamant, le saphir, le MgO, CeO2, YSZ, SrTiO3, BaTiO3, LaAlO3, le silicium

Selon un mode de mise en oeuvre, le substrat final comprend au moins un matériau compris dans la liste : Si, Ge, GaAs, Saphir, Alumine, verre, quartz, céramiques, plastique, métal, SiC, AIN.

Selon un mode de mise en oeuvre, le premier substrat comprend au moins un matériau compris dans la liste : polymère, BCB, PDMS, Polyimides, résines silicone, résines époxy, élastomères, film d'Aluminium, film de Cuivre, film de Molybdène, film de Tungstène, film de Nickel, film d'acier inoxydable, verres, matériaux poly cristallins, matériaux céramiques, matériaux frittés, oxydes, alumines, nitrures, silicates, carbures.

### BREVE DESCRIPTION DES DESSINS

L'invention sera mieux comprise à la lumière de la description qui suit des modes de réalisation, particuliers et non limitatifs, de l'invention en référence aux figures ci-jointes parmi lesquelles :
- la figure 1 est une vue du procédé de transfert selon l'art antérieur ;
- la figure 2 est une vue de dessus du substrat final comprenant des pavés obtenu selon l'art antérieur ;
- la figure 3 est une représentation schématique du procédé de transfert selon l'invention ;
- la figure 4 est une représentation schématique du procédé selon l'invention.

### DESCRIPTION DETAILLEE D'UN MODE DE REALISATION

Pour les différents modes de mise en oeuvre, les mêmes références seront utilisées pour des éléments identiques ou assurant la même fonction, par souci de simplification de la description.

Le procédé de transfert selon l'invention comprend une étape a. qui consiste à fournir un substrat intermédiaire 10.

Comme il sera expliqué par la suite de la description de la présente invention, le substrat intermédiaire 10 peut se déformer.

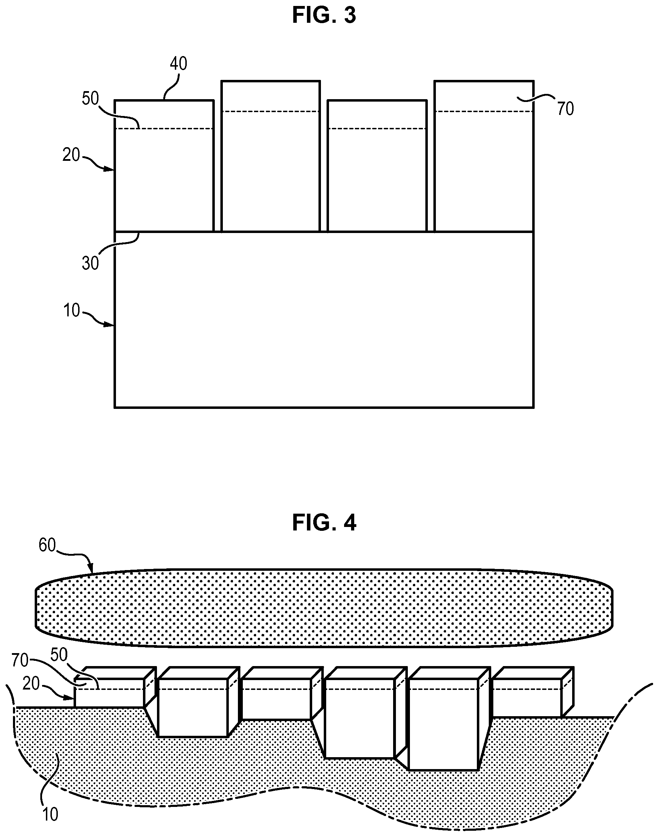

La déformation peut avoir pour objet de ramener sur le même plan moyen la face avant de l'ensemble des pavés 20, ou encore d'autoriser un léger pivotement des pavés 20 (figure 4), ou une combinaison.

### Nature du substrat intermédiaire 10

Le substrat intermédiaire 10 peut être un substrat de forme et de dimensions quelconques. Il peut en particulier être circulaire, et de diamètre supérieur à 100 millimètres, par exemple 200 millimètres ou encore 300 millimètres. Il peut être carré, ou rectangulaire et présenter des dimensions équivalentes.

Le substrat intermédiaire 10 comprend une première face dite face avant.

Le substrat intermédiaire 10 peut être massif (« Bulk » selon la terminologie anglo-saxonne) ou stratifié ou encore composé de sous-éléments présentant une certaine mobilité les uns par rapport aux autres.

Contrairement à l'usage dans le domaine des techniques d'assemblages de substrats et/ou de puces à l'échelle du substrat ("at wafer level" selon la terminologie Anglo-saxonne) selon lequel les substrats sont considérés comme non déformables, on recherchera ici à ce que le support intermédiaire puisse subir une certaine déformation.

La déformation peut être une déformation élastique et/ou plastique d'un des matériaux constituant le support intermédiaire et/ou résulter du mouvement de certains sous-ensembles de ce support intermédiaire.

Dans le cas où le support intermédiaire est un substrat massif, la déformation souhaitée peut être élastique, ou plastique ou une combinaison.

Dans le premier cas, la capacité du substrat intermédiaire 10 à se déformer élastiquement est quantifiée par son module de Young. Une déformation élastique du substrat intermédiaire 10 est réversible, de sorte que lorsqu'une contrainte s'exerçant sur le substrat intermédiaire 10 est relâchée, ce dernier reprend sa forme initiale.

Au contraire, une déformation plastique du substrat intermédiaire 10 n'est pas réversible. Mais le support peut généralement être à nouveau déformé par une nouvelle déformation plastique ou élastique ou une combinaison.

Bien que devant répondre à un cahier des charges assez serré, comme par exemple être compatible avec la température requise pour l'étape de détachement c., une large palette de matériaux est possible pour le choix de la nature du matériau composant le support intermédiaire.

Lorsque la température requise d'utilisation n'est pas très élevée, typiquement inférieure à 150-200°C, le matériau peut être un polymère. On pourra par exemple choisir parmi une longue liste connue de l'homme du métier : BCB (Benzocyclobutene), PDMS (Polydiméthylsiloxane), Polyimides, résines silicone, résines époxy, élastomères.... Ces substrats pourront être obtenus par différentes techniques classiques de réalisation, par exemple par moulage ou coulage ou sérigraphie, pour des épaisseurs typiques comprises entre 30 et 500µm.

Le matériau retenu pourra également être un film métallique, par exemple, d'Aluminium, de Cuivre, de Molybdène, de Tungstène, de Nickel, d'acier inoxydable. Certains de ces films sont également connus sous le nom de papier, par exemple "papier d'alu". L'épaisseur de ces films sera typiquement comprise entre 20 et 80µm.

Pour des opérations nécessitant des températures élevées, au-delà de 200°C, on pourra préférer des matériaux inorganiques, amorphes tels que des verres, et/ou des matériaux polycristallins, frittés ou non, que ce soit des oxydes, des alumines, des nitrures, des silicates, des carbures et plus généralement des matériaux céramiques. Dans ces cas on préférera des épaisseurs limitées en deçà de 150µm, voire 80µm.

La déformabilité des substrats supports peut également être obtenue grâce à une certaine texturation du matériau d'intérêt. Par exemple, on pourra abandonner des matériaux homogènes pour retenir une structure aérée. Il peut s'agir par exemple d'une structure en grille ("mesh" en terminologie anglo-saxonne) formée de fils du matériau d'intérêt, caractérisées entre autres par un diamètre de fil et une distance interfils. Le diamètre des fils est typiquement compris entre 30µm et 300µm, tandis que la distance interfils est typiquement comprise entre 50 µm et 1mm. Des épaisseurs totales pour le support intermédiaire de 40 à 150µm conviendront.

On pourra choisir par exemple des grilles en Aluminium, Nickel, Cuivre, Molybdène, ou encore en acier inoxydable, sans pour autant se limiter à des fils métalliques. Plusieurs techniques de réalisation de ces grilles peuvent être envisagées : moulage, laminage, soudage, tissage...

Par exemple, on pourra aussi s'orienter vers des papiers ou tissus réalisés à partir de fibres céramiques tels que de l'alumine ou à base d'autres matériaux réfractaires.

Des systèmes équivalents existent, caractérisés par des organisations plus désordonnées qu'une grille régulière. Par exemple des structures connues sous l'appellation de mousse (mousse d'Aluminium, de Cuivre, de Nickel, ...) ou encore "foam" en terminologie anglo-saxonne correspondent à un réel enchevêtrement. Une structure aérée peut également correspondre à un matériau poreux, la porosité pouvant être obtenue dès la formation du substrat intermédiaire 10 grâce au procédé de fabrication de ce dernier, ou par traitement postérieur telle qu'une gravure électrochimique. La nature du matériau poreux peut varier. Par exemple, ce peut être un métal, comme le nickel poreux. Par exemple ce peut aussi être un semi-conducteur comme le silicium poreux.

Au-delà d'un matériau homogène, structuré ou non, le matériau constituant le substrat peut être un matériau composite ou être hétérogène par nature. A titre d'exemple sa composition peut être obtenue en distribuant des particules d'un premier matériau dans une matrice d'un second matériau. Le premier matériau peut se présenter sous plusieurs formes, comme par exemple des nanoparticules, de SiO₂ ou d'autres matériaux.

A titre d'exemple supplémentaire, le substrat intermédiaire 10 peut présenter une armature noyée dans une matrice. Par exemple les grilles ou mousses métalliques précédemment citées peuvent être imprégnées d'un deuxième matériau, tel qu'un polymère, ou une céramique.

Le substrat intermédiaire 10 peut également être stratifié. Par substrat stratifié, on entend un substrat intermédiaire 10 comprenant un empilement d'un substrat support et d'une couche additionnelle.

Dans le cas d'un substrat stratifié, la face avant du substrat intermédiaire 10 est la face formée par la surface libre de la couche additionnelle.

Toujours dans le cas d'un substrat stratifié, la déformation ne s'applique pas obligatoirement à l'ensemble de la structure mais peut être localisée préférentiellement dans une ou plusieurs couches additionnelles.

Par exemple, le support intermédiaire peut être composé d'une couche additionnelle de 70µm de PDMS apportant une certaine déformabilité, couche de PDMS déposée sur un support silicium de 725µm d'épaisseur, comparativement beaucoup plus rigide. Le PDMS peut être remplacé par d'autres matériaux tels que des élastomères ou autres polymères, par exemple du BCB.

La déformation du substrat intermédiaire 10 peut être une déformation obtenue non pas seulement par déformation d'un élément de matériau, mais peut être autorisée grâce à la mise en liberté de mouvement relatif de certains sous-ensembles de ce substrat intermédiaire 10. Pour reprendre l'exemple des substrats stratifiés, des cavités peuvent être réalisées et positionnées localement aux endroits pertinents sous la couche additionnelle, rendant sa déformation plus facile. Les dites cavités peuvent être étanches ou non, et contenir de l'air ou un gaz à une pression contrôlée. Les cavités évidées peuvent également être remplies d'un matériau déformable par nature comme un polymère, ou par structure comme une mousse. La liberté de mouvement peut également devenir une obligation de mouvement sous la commande de certains actuateurs et micromoteurs. De tels supports intermédiaires pourront être avantageusement fabriqués avec des technologies empruntées aux micro-technologies MEMS.

### Contrainte provoquant la déformation du substrat intermédiaire 10

La déformation peut être provoquée à partir de plusieurs types de contraintes. Pour les cas où l'assemblage s'opère de proche en proche par propagation d'une onde de collage, comme par exemple dans le cas d'un collage par adhésion moléculaire, une déformation peut être obtenue par le rapprochement naturel des pièces qui sont entrées dans le processus d'assemblage de proche en proche. La déformation peut aussi être provoquée par la gravité, par exemple sous le propre poids des pavés 20 et/ou du substrat intermédiaire 10, qui dans ce cas sera placé avantageusement au dessus du substrat final 60. La déformation peut aussi être provoquée par d'autres forces extérieures, globales ou localisées. Un opérateur peut ainsi venir appuyer à l'aplomb de chacun des pavés 20, successivement ou simultanément. Le passage d'un outil de type rouleau peut avoir cet effet. Cette opération pourra également être opérée automatiquement par une machine. On pourra également faire appel à une mise sous pression, par exemple d'air comprimé, pression qu'il sera commode d'ajuster en fonction des surfaces à mettre à assembler et du mode d'assemblage. La contrainte pourra également résulter de phénomènes d'attraction entre les pavés 20 et la surface d'accueil du substrat final 60. Par exemple dans le cas d'un collage anodique (anodic bonding en terminologie anglo-saxonne), des forces d'attraction électrostatique pourront être utilisées.

### Nature des pavés 20

Toujours selon l'étape a., de la présente invention, des pavés 20 sont assemblés par une première face principale 30 sur la face avant du substrat intermédiaire 10.

Les pavés 20 comprennent une surface libre 40 opposée à ladite première face principale 30.

Dans le cas d'un substrat intermédiaire 10 sous forme de substrat stratifié, les pavés 20 sont donc disposés sur la surface libre de la couche additionnelle.

La surface libre 40 des pavés 20 peut être de forme carrée, rectangulaire, hexagonale, polygonale ou circulaire.

La surface libre 40 d'un pavé 20 de forme circulaire peut présenter un diamètre compris entre quelques fractions de mm et quelques dizaines de mm.

La surface libre 40 d'un pavé 20 de forme carrée peut présenter un côté compris entre quelques fractions de mm et quelques centaines de mm.

La surface libre 40 d'un pavé 20 de forme rectangulaire peut présenter une longueur comprise entre quelques fractions de mm et quelques centaines de mm (par exemple entre 0.5 mm et 5 mm, voire entre 0.5 mm et 10 mm), et une largeur comprise entre quelques fractions de mm et quelques centaines de mm (par exemple entre 0.5 mm et 5 mm, voire entre 0.5 mm et 10 mm), avec des facteurs de forme extrêmes proches d'un carré ou au contraire des rectangles très allongés, par exemple 5mm x 200mm.

Les pavés 20 peuvent être disposés de manière régulière sur le substrat intermédiaire 10, par exemple pour former un quadrillage. La répartition des pavés 20 peut suivre d'autres organisations périodiques, par exemple sous forme de distribution en quinconce. Dans le cas de pavés 20 hexagonaux, une distribution hexagonale compacte permettra une optimisation de la surface couverte.

La distance entre deux pavés 20 adjacents peut au choix varier de zéro à quelques mms (par exemple entre 0.1 mm et 1 mm, voire entre 0.1 mm et 2 mm). Choisir pour cette distance des valeurs élevées, dans la gamme du mm, peut en effet aider à accommoder la déformation requise du support intermédiaire lors de l'étape b d'assemblage

Les pavés 20 peuvent comprendre au moins un matériau compris dans la liste : SiC, GaN, GaAs, InP, GaSb, GaP, InAs, Ge, ZnO, LiTaO₃, LiNbO₃, diamant, saphir, MgO, CeO₂, YSZ, SrTiO₃, BaTiO₃, LaAlO₃, silicium.

Si les pavés 20 proviennent du même lot de fabrication ou de lots similaires, la différence d'épaisseur entre le pavé 20 le plus fin et le pavé 20 le plus épais est typiquement inférieure à 50 µm, voire inférieure à 2 µm. La technique d'assemblage de ces pavés 20 sur le support intermédiaire peut rajouter une variabilité équivalente, quant au positionnement de la face avant des pavés 20. Au total, les différences de positionnement à compenser lors de l'étape d'assemblage b sont donc typiquement comprises entre 0 et 50µm. La déformation du support intermédiaire doit permettre de compenser ces valeurs.

Dans un mode particulier, tous les pavés 20 sont de nature identique.

Dans d'autres modes, on combinera des pavés 20 de natures différentes, par exemple un pavé 20 sur deux en GaAs et l'autre en InP. Dans ce cas, la surface respective des pavés 20 peut être différente, par exemple 1mmx10mm pour les pavés 20 en InP et 9mmx10mm pour les pavés 20 en GaAs. Dans ce cas également les épaisseurs nominales respectives peuvent être différentes, avec des épaisseurs qui pourraient être par exemple de 625µm pour les pavés 20 en InP et de 575µm en GaAs. Dans ce cas, la valeur moyenne des différences d'épaisseur à rattraper est de 50µm. Au lieu d'utiliser une étape d'enlèvement de matière pour récupérer cet écart, la présente invention repose sur une déformation équivalente du substrat intermédiaire 10.

Par pavé 20 de nature différente, il faut aussi entendre des cas où il s'agit du même matériau mais avec au moins une propriété différente, par exemple une orientation cristalline, un dopage, une teneur en oxygène, une teneur d'alliage. Par exemple des pavés 20 de Si à faible teneur en oxygène combinés avec des pavés 20 de Si à faible teneur en oxygène, ou encore des pavés 20 de SiGe à teneur en Ge à 20% combinés avec des pavés 20 de SiGe à teneur en Ge à 40%. Provenant alors de lingots et/ou de sources différentes, ou présentant des caractéristiques différentes, on peut en effet s'attendre dans ce cas à ce que cette différence se répercute en une différence d'épaisseur des pavés 20 d'origine.

Par ailleurs, dans le cas de pavés 20 de nature différente, tous les pavés 20 ne présentent pas la même vitesse de polissage lors d'une étape de polissage mécano-chimique telle que décrite dans l'art antérieur US 6,562,127 B1.

### Adhésion des pavés 20 sur le support intermédiaire

Les pavés 20 peuvent être maintenus sur le substrat intermédiaire 10 par adhésion moléculaire.

Une ou plusieurs couches de collage peuvent être formées afin de faciliter l'adhésion moléculaire. Une telle couche peut être obtenue par dépôt. Elle peut être déposée sur les pavés 20 et/ou sur le substrat intermédiaire 10 avant l'étape d'adhésion moléculaire. Cette couche peut par exemple être une couche de SiO₂. Un léger recuit de lissage ou encore polissage mécano-chimique peut être réalisé après l'étape de dépôt, moins dans le but de rattraper une différence de niveau que pour améliorer un état de surface que le dépôt aurait pu dégrader.

L'adhésion moléculaire des pavés 20 sur le substrat intermédiaire 10 peut également être renforcée par un recuit thermique après assemblage.

Par exemple, des pavés 20 carrés de GaN monocristallin de 5cm de côté sont disposés sur un substrat intermédiaire 10 en Molybdène, ce dernier se présentant sous la forme d'un film métallique d'épaisseur 25µm. 9 substrats GaN sont assemblés sur ce film dans une configuration carrée 3 en vertical x 3 en horizontal. La distance entre deux carrés adjacents est de 2mm, menant à une surface totale de Molybdène d'environ 20 x 20 cm².

Au préalable, chacune des surfaces à mettre en contact a été recouverte par dépôt d'une couche de SiO₂ de 150nm d'épaisseur. Après mise en contact et application d'une légère contrainte accompagnant un mouvement de laminage, l'ensemble est chauffé à une température comprise entre 800 et 1200°C, pendant une durée comprise entre 5mns et 2h.

Les pavés 20 peuvent être également maintenus sur le substrat intermédiaire 10 par l'intermédiaire d'un matériau adhésif. Ce matériau adhésif peut être, notamment dans les cas les moins exigeants en termes de température de traitement lors de l'étape c. de détachement, une colle relativement standard. On pourra alors choisir parmi les colles polymères, les résines époxy, les résines acryliques, les résines silicone, les Polyimides. Notamment pour des températures moins tolérantes, ce matériau adhésif peut aussi être choisi dans d'autres familles de colle, comme les ciments ou encore les colles céramique à base d'alumine ou de silice ou de nitrure d'aluminium ou de zircone ou d'oxyde de magnésium ou de carbure de silicium par exemple.

Selon un exemple, des pavés 20 carrés de YSZ monocristallins de 2 x 2 cm² sont assemblés sur un substrat intermédiaire 10 qui se présente sous forme d'une grille flexible de Nickel d'épaisseur 60µm. L'assemblage est réalisé grâce à une colle céramique à base d'alumine, qui aura de plus l'avantage d'imprégner le support en forme de grille. L'ensemble est ensuite recuit, par exemple entre 250 et 600°C pendant au moins 2h.

Au lieu de recourir à un assemblage des pavés 20 avec un substrat intermédiaire 10 déjà formé, on peut également former le substrat intermédiaire 10 par dépôt ou moulage de celui-ci sur l'ensemble des pavés 20 qui auront été pré-positionnés.

Selon un exemple, il s'agit d'assembler des pavés 20 hexagonaux d'InP monocristallins, de dimension définie de sorte que chaque hexagone s'inscrive dans un cercle de 50mm de diamètre. Les hexagones sont pré-positionnés sur un support plan pour former un réseau hexagonal compact, une distance de 1 mm séparant les bords de chacun des pavés 20. Sur ces pavés 20 est ensuite formé par moulage un support intermédiaire en PDMS d'épaisseur 80µm.

### Etape b d'assemblage

Le procédé selon l'invention comprend une étape b. d'assemblage de la surface libre 40 des pavés 20 avec un substrat final 60.

Selon l'état de l'art, les pavés 20 ne présentent pas tous la même épaisseur. L'épaisseur d'un pavé 20 étant définie comme la distance entre la première face principale 30 et la surface libre 40 dudit pavé 20.

Ainsi, lors de l'étape d'assemblage, le substrat intermédiaire 10 se déforme de sorte que les surfaces libres des pavés 20 deviennent coplanaires. La déformation du substrat intermédiaire 10 rentre en jeu comme décrit en section « *Contrainte provoquant la déformation* ».

Par conséquent, toutes les surfaces libres des pavés 20 présents sur un substrat intermédiaire 10 sont en contact avec le substrat final 60 à l'issue de l'étape d'assemblage.

L'étape d'assemblage b. est réalisée de manière similaire à celle qui est employée dans le cadre de collage de substrats continus (non sous forme de pavés) pour le transfert de couches.

Elle peut en particulier comprendre une étape d'adhésion moléculaire. Une ou plusieurs couches de collage peuvent être formées afin de faciliter l'adhésion moléculaire. Une telle couche peut être obtenue par dépôt ou oxydation thermique ou autre traitement équivalent. Elle peut être déposée sur les pavés 20 recouvrant le support intermédiaire et/ou sur le support final avant l'étape d'adhésion moléculaire. Cette couche peut par exemple être une couche de SiO₂. Un léger recuit de lissage ou encore polissage mécano-chimique peut être réalisé après l'étape de dépôt. L'adhésion moléculaire des pavés 20 sur le substrat intermédiaire 10 peut également être renforcée par un recuit thermique après assemblage.

Avant l'étape d'assemblage b, le procédé selon l'invention peut comprendre la formation d'une couche d'assemblage sur la surface libre 40 des pavés 20 et/ou sur une face du substrat final 60.

Ainsi, la couche d'assemblage se trouve intercalée entre le substrat final 60 et la surface libre 40 des pavés 20 à l'issue de l'étape d'assemblage b.

La couche d'assemblage peut comprendre une colle polymère ou un ciment.

Mais l'étape d'assemblage b. peut aussi être toute autre technique équivalente, connue de l'homme du métier : collage anodique, collage eutectique, collage avec adhésif, ... On pourra par exemple se référer à l'ouvrage « Wafer bonding : applications and technology », M. Alexe, U. Gösele (Eds.), Springer series in materials science, ISSN 0933-033X ; 75.

### Etape c. de détachement

Selon l'étape a., les pavés 20 comprennent, chacun, une zone de fragilisation 50.

La zone de fragilisation 50 de chacun des pavés 20 est essentiellement parallèle à la surface libre 40 desdits pavés 20.

Pour chaque pavé 20, la zone de fragilisation 50 et la surface libre 40 délimitent une portion de pavé 70 destinée à être transférée sur un substrat final 60.

La zone de fragilisation 50 peut être formée par implantation d'espèces ioniques. Par exemple, les espèces ioniques peuvent comprendre au moins une des espèces choisie parmi : hydrogène, hélium, gaz nobles.

A cet égard, l'homme du métier pourra se référer au brevet US 5,374,564 B1.

La fragilisation peut également être obtenue à l'aide d'autres moyens. Par exemple, il peut s'agir d'une couche enterrée poreuse. Par exemple dans le cas du silicium, un silicium monocristallin peut être rendu localement poreux par une anodisation électrochimique en bain HF-Ethanol. A cet égard, l'homme du métier pourra se référer au brevet US 5 854 123.

La fragilisation peut aussi correspondre à un changement de composition au sein d'une couche enterrée ou encore à une interface entre deux matériaux différents, notamment si l'un d'entre eux est mis en contrainte du fait de la différence de son paramètre de maille cristallin par rapport à son substrat de croissance. Ceci peut par exemple être le cas lors de la réalisation par épitaxie d'empilements Si/SiGe.

La fragilisation peut aussi être provoquée suite à une irradiation laser provoquant en profondeur une zone défectueuse.

Le détachement, sensiblement le long de la zone fragilisée, peut généralement être provoqué en faisant mûrir la zone de fragilisation 50, par exemple à l'aide d'un recuit. Elle peut aussi faire suite à l'application d'une contrainte mécanique extérieure, comme un effort de cisaillement, de pelage, de traction etc. Cette contrainte peut aussi résulter en partie de différences de dilatation des matériaux entrant en jeu. Le détachement peut aussi résulter de l'utilisation d'une sous-gravure chimique (souvent appelée lift-off en terminologie Anglo-saxonne) permettant de graver sélectivement une couche enterrée ou de corroder une interface enterrée.

### Substrat final 60

Le choix du substrat final 60 est opéré de manière similaire à celui réalisé dans le cadre de collages de substrats non-pavés pour le transfert de couches. Ce choix est guidé en grande partie par les conditions d'utilisation de celui-ci et par l'application finale.

Selon les cas, le substrat final 60 peut être rigide ou non, de forme et de dimensions quelconque, organique ou non, être monocristallin, polycristallin, amorphe. Il peut comprendre au moins un matériau compris dans la liste : Si, Ge, GaAs, Saphir, Alumine, verre, quartz, céramiques, plastique, métal, SiC, AIN.

### Produit

Ainsi, à la suite de l'étape b. d'assemblage, on obtient un empilement comprenant :
un premier substrat comprenant, sur une face principale, des pavés 20 assemblés selon une première face principale 30 au premier substrat, ladite face principale du premier substrat étant plane lorsque le premier substrat est à l'état libre, les pavés 20 étant en matériau monocristallin, et comprenant une zone de fragilisation 50.

L'empilement comprend également un second substrat assemblé selon une seconde face principale des pavés 20 opposée à la première face principale 30 desdits pavés, la face principale du premier substrat étant déformée de sorte que les secondes faces principales des pavés 20 sont coplanaires.

Le second substrat peut être assemblé à la seconde face des pavés 20 par adhésion moléculaire.

Les pavés 20 peuvent présenter une épaisseur égale à la distance entre la première face et la seconde face dudit pavé 20, la différence d'épaisseur entre le pavé 20 le plus fin et le pavé 20 le plus épais est inférieure à 50 µm, de préférence inférieure à 5 µm.

Les pavés 20 peuvent comprendre une zone de fragilisation 50, la zone de fragilisation 50 et la seconde face de chaque pavé 20 délimitant une portion de pavé 70 destinée à être transférée sur le second substrat, la zone de fragilisation 50 de chacun des pavés 20 étant formée par implantation d'espèces ioniques.

Les pavés 20 peuvent comprendre au moins un matériau compris dans la liste : le SiC, le GaN, le GaAs, l'InP, le GaSb, le GaP, l'InAs, le Ge, le ZnO, le LiTaO₃, le LiNbO3, le diamant, le saphir, le MgO, CeO2, YSZ, SrTiO3, BaTiO3, LaAlO3, le silicium.

Le substrat final 60 peut comprendre au moins un matériau compris dans la liste : Si, Ge, GaAs, Saphir, Alumine, verre, quartz, céramiques, plastique, metal, SiC, AIN.

Le premier substrat peut comprendre au moins un matériau compris dans la liste : polymère, BCB, PDMS, Polyimides, résines silicone, résines époxy, élastomères, film d'Aluminium, film de Cuivre, film de Molybdène, film de Tungstène, film de Nickel, film d'acier inoxydable, verres, matériaux poly cristallins, matériaux céramiques, matériaux frittés, oxydes, alumines, nitrures, silicates, carbures.

### REFERENCES

US 6,562,127
Wafer bonding : applications and technology, M. Alexe, U. Gösele (Eds.), Springer series in materials science, ISSN 0933-033X ; 75
US 5,374,564
US 5,854,123

## Revendications

1. Procédé de transfert comprenant les étapes :
a. Fournir un substrat intermédiaire (10), le substrat intermédiaire (10) comprenant, sur une de ses faces, des pavés (20) assemblés par une première face principale (30) au substrat intermédiaire (10), lesdits pavés (20) présentant une surface libre (40) opposée à ladite première face principale (30), et sont en matériau monocristallin, les pavés (20) comprenant une zone de fragilisation (50), la zone de fragilisation (50) et la surface libre (40) de chaque pavé, délimitant une portion de pavé (70) destinée à être transférée sur un substrat final (60) ;
b. Exécuter une étape d'assemblage en mettant en contact la surface libre (40) de chacun des pavés (20) avec le substrat final (60) ;
c. Exécuter, après l'étape d'assemblage, un détachement au niveau de la zone de fragilisation (50) de chacun des pavés (20) de manière à transférer la portion de pavé (70) de chacun des pavés (20) sur le substrat final (60) ;
ledit procédé de transfert étant **caractérisé en ce que** lors de l'étape d'assemblage, le substrat intermédiaire (10) se déforme de sorte que les surfaces libres des pavés (20) deviennent coplanaires.

2. Procédé de transfert selon la revendication 1, dans lequel l'étape b d'assemblage est une étape d'adhésion moléculaire.

3. Procédé de transfert selon la revendication 1, dans lequel une couche d'assemblage est intercalée entre le substrat final (60) et les pavés (20) avant l'étape b d'assemblage.

4. Procédé de transfert selon l'une des revendications 1 à 3 dans lequel les pavés (20) présentent une épaisseur égale à la distance entre la première face principale (30) et la surface libre (40) dudit pavé (20), la différence d'épaisseur entre le pavé (20) le plus fin et le pavé (20) le plus épais est inférieure à 50 µm, de préférence inférieure à 5 µm.

5. Procédé de transfert selon l'une des revendications 1 à 4, dans lequel la zone de fragilisation (50) de chacun des pavés (20) est formée par implantation d'espèces ioniques.

6. Procédé de transfert selon la revendication 5, dans lequel l'étape c. de détachement comprend un traitement thermique.

7. Procédé de transfert selon l'une des revendications 1 à 6, dans lequel le substrat intermédiaire (10) comprend au moins un matériau compris dans la liste : polymère, BCB, PDMS, Polyimides, résines silicone, résines époxy, élastomères. film d'Aluminium, film de Cuivre, film de Molybdène, film de Tungstène, film de Nickel, film d'acier inoxydable, verres, matériaux poly cristallins, matériaux céramiques, matériaux frittés, oxydes, alumines, nitrures, silicates, carbures.

8. Procédé de transfert selon l'une des revendications 1 à 7, dans lequel le substrat intermédiaire (10) comprend une structure comprise dans la liste : structure en grille, structure en tissu, structure en mousse, structure poreuse, matériau composite.

9. Procédé de transfert selon l'une des revendications 1 à 8, dans lequel le substrat intermédiaire (10) est stratifié et comprend au moins une couche additionnelle susceptible de se déformer.

10. Procédé de transfert selon l'une des revendications 1 à 9, dans lequel les pavés (20) comprennent au moins un matériau compris dans la liste : le SiC, le GaN, le GaAs, l'InP, le GaSb, le GaP, l'InAs, le Ge, le ZnO, le LiTaO₃, le LiNbO₃, le diamant, le saphir, le MgO, CeO₂, YSZ, SrTiO₃, BaTiO₃, LaAlO₃, le silicium.

11. Procédé de transfert selon l'une des revendications 1 à 10, dans lequel les pavés (20) comprennent un premier type de pavés (20) et un second type de pavés (20) de nature chimique différente du premier type de pavés (20).

12. Procédé de transfert selon l'une des revendications 1 à 11, dans lequel la surface libre (40) des pavés (20) présente une forme carrée, rectangulaire, circulaire ou hexagonale.

13. Procédé de transfert selon l'une des revendications 1 à 12, dans lequel le substrat final (60) comprend au moins un matériau compris dans la liste : Si, Ge, GaAs, Saphir, Alumine, verre, quartz, céramiques, plastique, métal, SiC, AIN.

14. Empilement comprenant :
un premier substrat comprenant, sur une face principale, des pavés (20) assemblés selon une première face principale (30) au premier substrat, ladite face principale du premier substrat étant plane lorsque le premier substrat est à l'état libre, les pavés (20) étant en matériau monocristallin, et comprenant une zone de fragilisation (50),
l'empilement étant **caractérisé en ce qu'**il comprend un second substrat assemblé selon une seconde face principale des pavés (20) opposée à la première face principale (30) desdits paves, la face principale du premier substrat étant déformée de sorte que les secondes faces principales des pavés (20) sont coplanaires.

15. Empilement selon la revendication 14, dans lequel le second substrat est assemblé à la seconde face des pavés (20) par adhésion moléculaire.

16. Empilement selon la revendication 14 ou 15, dans lequel les pavés (20) présentent une épaisseur égale à la distance entre la première face et la seconde face dudit pavé (20), la différence d'épaisseur entre le pavé (20) le plus fin et le pavé (20) le plus épais est inférieure à 50 µm, de préférence inférieure à 5 µm.

17. Empilement selon l'une des revendications 14 à 16, dans lequel les pavés (20) comprennent une zone de fragilisation (50), la zone de fragilisation (50) et la seconde face de chaque pavé (20) délimitant une portion de pavé (70) destinée à être transférée sur le second substrat, la zone de fragilisation (50) de chacun des pavés (20) étant formée par implantation d'espèces ioniques.

18. Empilement selon l'une des revendications 14 à 17, dans lequel les pavés (20) comprennent au moins un matériau compris dans la liste : le SiC, le GaN, le GaAs, l'InP, le GaSb, le GaP, l'InAs, le Ge, le ZnO, le LiTaO₃, le LiNbO3, le diamant, le saphir, le MgO, CeO2, YSZ, SrTiO3, BaTiO3, LaAlO3, le silicium.

19. Empilement selon l'une des revendications 14 à 18, dans lequel le substrat final (60) comprend au moins un matériau compris dans la liste : Si, Ge, GaAs, Saphir, Alumine, verre, quartz, céramiques, plastique, metal, SiC, AIN.

20. Empilement selon l'une des revendications 14 à 19, dans lequel le premier substrat comprend au moins un matériau compris dans la liste : polymère, BCB, PDMS, Polyimides, résines silicone, résines époxy, élastomères. film d'Aluminium, film de Cuivre, film de Molybdène, film de Tungstène, film de Nickel, film d'acier inoxydable, verres, matériaux poly cristallins, matériaux céramiques, matériaux frittés, oxydes, alumines, nitrures, silicates, carbures.

## Patentansprüche

1. Übertragungsverfahren, umfassend die Schritte:
a. Liefern eines Zwischensubstrats (10), wobei das Zwischensubstrat (10) auf einer seiner Seiten Klötze (20) umfasst, die von einer ersten Hauptseite (30) an dem Zwischensubstrat (10) montiert sind, wobei die genannten Klötze (20) eine freie Oberfläche (40) aufweisen, die der genannten ersten Hauptseite (30) entgegengesetzt ist und aus einem Einkristall-Material sind, wobei die Klötze (20) einen Versprödungsbereich (50) umfassen, wobei der Versprödungsbereich (50) und die freie Fläche (40) jedes Klotzes einen Klotzabschnitt (70) begrenzen, der dazu bestimmt ist, auf einem endgültigen Substrat (60) übertragen zu sein;
b. Ausführen eines Montageschritts durch Kontaktieren der freien Fläche (40) jedes der Klötze (20) mit dem endgültigen Substrat (60);
c. Ausführen eines Ablösens nach dem Montageschritt an dem Versprödungsbereich (50) jedes der Klötze (20) derart, dass der Klotzabschnitt (70) jedes der Klötze (20) auf das endgültige Substrat (60) übertragen ist;
wobei das genannte Übertragungsverfahren **dadurch gekennzeichnet ist, dass** das Zwischensubstrat (10) beim Montageschritt sich derart verformt, dass die freien Flächen der Klötze (20) koplanar werden.

2. Übertragungsverfahren gemäß Anspruch 1, bei dem der Montageschritt ein molekularer Adhäsionsschritt ist.

3. Übertragungsverfahren gemäß Anspruch 1, bei dem eine Montageschicht zwischen dem endgültigen Substrat (60) und den Klötzen (20) vor dem Montageschritt b zwischengeschaltet ist.

4. Übertragungsverfahren gemäß einem der Ansprüche 1 bis 3, bei dem die Klötze (20) eine Dicke gleich der Entfernung zwischen der ersten Hauptseite (30) und der freien Fläche (40) des genannten Klotzes (20) aufweisen, wobei der Dickenunterschied zwischen dem dünnsten und dem dicksten Klotz (20) unter 50 µm, bevorzugt unter 5 µm beträgt.

5. Übertragungsverfahren gemäß einem der Ansprüche 1 bis 4, bei dem der Versprödungsbereich (50) jedes der Klötze (20) per Einsetzen von ionischen Sorten gebildet ist.

6. Übertragungsverfahren gemäß Anspruch 5, bei dem der Ablösungsschritt c eine Wärmebehandlung umfasst.

7. Übertragungsverfahren gemäß einem der Ansprüche 1 bis 6, bei dem das Zwischensubstrat (10) wenigstens ein Material umfasst, das in der Liste inbegriffen ist: Polymer, BCB, PDMS, Polyimide, Silikonharze, Epoxidharze, Elastomere, Aluminiumfolie, Kupferfolie, Molybdänfolie, Wolframfolie, Nickelfolie, Edelstahlfolie, Glassorten, Polykristall-Materialien, Keramikmaterialien, gesinterte Materialien, Oxide, Aluminiumoxide, Nitride, Silikate, Karbide.

8. Übertragungsverfahren gemäß einem der Ansprüche 1 bis 7, bei dem das Zwischensubstrat (10) eine Struktur umfasst, die in der Liste inbegriffen ist: Gitterstruktur, Stoffstruktur, Schaumstoffstruktur, poröse Struktur, Verbundmaterial.

9. Übertragungsverfahren gemäß einem der Ansprüche 1 bis 8, bei dem das Zwischensubstrat (10) schichtig ist und wenigstens eine zusätzliche Schicht umfasst, die geeignet ist, sich zu verformen.

10. Übertragungsverfahren gemäß einem der Ansprüche 1 bis 9, bei dem die Klötze (20) wenigstens ein Material umfassen, das in der Liste inbegriffen ist: SiC, GaN, GaAs, InP, GaSb, GaP, InAs, Ge, ZnO, LiTaO₃, LiNbO₃, Diamant, Saphir, MgO, CeO₂, YSZ, SrTiO₃, BaTiO₃, LaAlO₃, Silizium.

11. Übertragungsverfahren gemäß einem der Ansprüche 1 bis 10, bei dem die Klötze (20) einen ersten Typ von Klötzen (20) und einen zweiten Typ von Klötzen (20) von vom ersten Typ von Klötzen (20) unterschiedlicher chemischer Art umfassen.

12. Übertragungsverfahren gemäß einem der Ansprüche 1 bis 11, bei dem die freie Fläche (40) der Klötze (20) eine quadratische, rechteckige, kreisförmige oder sechseckige Form aufweist.

13. Übertragungsverfahren gemäß einem der Ansprüche 1 bis 12, bei dem das endgültige Substrat (60) wenigstens ein Material umfasst, das in der Liste inbegriffen ist: Si, Ge, GaAs, Saphir, Aluminiumoxid, Glas, Quarz, Keramik, Plastik, Metall, SiC, AIN.

14. Stapelung, umfassend:
ein erstes Substrat, auf einer Hauptseite umfassend Klötze (20), die gemäß einer ersten Hauptseite (30) auf dem ersten Substrat montiert sind, wobei die genannte Hauptseite des ersten Substrats eben ist, wenn das erste Substrat im freien Zustand ist, wobei die Klötze (20) auf Einkristall-Material sind und einen Versprödungsbereich (50) umfassen,
wobei die Stapelung **dadurch gekennzeichnet ist, dass** sie ein zweites Substrat umfasst, das gemäß einer zweiten Hauptseite der Klötze (20) montiert ist, die der ersten Hauptseite (30) der genannten Klötze entgegengesetzt ist, wobei die Hauptseite des ersten Substrats derart verformt ist, dass die zweiten Hauptseiten der Klötze (20) koplanar sind.

15. Stapelung gemäß Anspruch 14, bei der das zweite Substrat per molekularer Adhäsion an der zweiten Seite der Klötze (20) montiert ist.

16. Stapelung gemäß Anspruch 14 oder 15, bei der die Klötze (20) eine Dicke gleich der Entfernung zwischen der ersten Seite und der zweiten Seite des genannten Klotzes (20) aufweisen, der Dickenunterschied zwischen dem dünnsten Klotz (20) und dem dicksten Klotz (20) unter 50 µm, bevorzugt unter 5 µm beträgt.

17. Stapelung gemäß einem der Ansprüche 14 bis 16, bei der die Klötze (20) einen Versprödungsbereich (50) umfassen, wobei der Versprödungsbereich (50) und die zweite Seite jedes Klotzes (20) einen Klotzabschnitt (70) begrenzen, der dazu bestimmt ist, auf das zweite Substrat übertragen zu sein, wobei der Versprödungsbereich (50) jedes der Klötze (20) per Einsetzen von ionischen Sorten gebildet ist.

18. Stapelung gemäß einem der Ansprüche 14 bis 17, bei der die Klötze (20) wenigstens ein Material umfassen, das in der Liste inbegriffen ist: SiC, GaN, GaAs, InP, GaSb, GaP, InAs, Ge, ZnO, LiTaO₃, LiNbO₃, Diamant, Saphir, MgO, CeO₂, YSZ, SrTiO₃, BaTiO₃, LaAlO₃, Silizium.

19. Stapelung gemäß einem der Ansprüche 14 bis 18, bei der das endgültige Substrat (60) wenigstens ein Material umfasst, das in der Liste inbegriffen ist: Si, Ge, GaAs, Saphir, Aluminiumoxid, Glas, Quarz, Keramik, Plastik, Metall, SiC, AIN.

20. Stapelung gemäß einem der Ansprüche 14 bis 19, bei der das erste Substrat wenigstens ein Material umfasst, das in der Liste inbegriffen ist: Polymer, BCB, PDMS, Polyimide, Silikonharze, Epoxidharze, Elastomere, Aluminiumfolie, Kupferfolie, Molybdänfolie, Wolframfolie, Nickelfolie, Edelstahlfolie, Glassorten, Polykristall-Materialien, Keramikmaterialien, gesinterte Materialien, Oxide, Aluminiumoxide, Nitride, Silikate, Karbide.

## Claims

1. A transfer method comprising the steps:
a. providing an intermediate substrate (10), the intermediate substrate (10) comprising, on one of its faces, blocks (20) assembled by a first main face (30) to the intermediate substrate (10), said blocks (20) having a free surface (40) opposite to said first main face (30), and are in a single-crystal material, the blocks (20) comprising an embrittlement area (50), the embrittlement area (50) and the free surface (40) of each block, delimiting a block portion (70) intended to be transferred onto a final substrate (60);
b. executing an assembling step by putting the free surface (40) of each of the blocks (20) in contact with the final substrate (60);
c. executing, after the assembling step, a detachment at the embrittlement area (50) of each of the blocks (20) so as to transfer the block portion (70) of each of the blocks (20) onto the final substrate (60);
said transfer method being **characterized in that** during the assembling step, the intermediate substrate (10) deforms so that the free surfaces of the blocks (20) become coplanar.

2. The transfer method according to claim 1, wherein the assembling step b is a molecular adhesion step.

3. The transfer method according to claim 1, wherein an assembling layer is inserted between the final substrate (60) and the blocks (20) before the assembling step b.

4. The transfer method according to one of claims 1 to 3, wherein the blocks (20) have a thickness equal to the distance between the first main face (30) and the free surface (40) of said block (20), the thickness difference between the thinnest block (20) and the thickest block (20) is less than 50 µm, preferably less than 5 µm.

5. The transfer method according to one of claims 1 to 4, wherein the embrittlement area (50) of each of the blocks (20) is formed by implantation of ionic species.

6. The transfer method according to claim 5, wherein the detachment step c. comprises a heat treatment.

7. The transfer method according to one of claims 1 to 6, wherein the intermediate substrate (10) comprises at least one material comprised in the list: polymer, BCB, PDMS, polyimides, silicone resins, epoxy resins, elastomers, aluminum film, copper film, molybdenum film, tungsten film, nickel film, stainless steel film, glasses, polycrystalline materials, ceramic materials, sintered materials, oxides, aluminas, nitrides, silicates, carbides.

8. The transfer method according to one of claims 1 to 7, wherein the intermediate substrate (10) comprises a structure comprised in the list: mesh structure, fabric structure, foam structure, porous structure, composite material.

9. The transfer method according to one of claims 1 to 8, wherein the intermediate substrate (10) is laminated and comprises at least one additional layer which may deform.

10. The transfer method according to one of claims 1 to 9, wherein the blocks (20) comprise at least one material comprised in the list: SiC, GaN, GaAs, InP, GaSb, GaP, InAs, Ge, ZnO, LiTaO₃, LiNbO₃, diamond, sapphire, MgO, CeO₂, YSZ, SrTiO₃, BaTiO₃, LaAlO₃, silicon.

11. The transfer method according to one of claims 1 to 10, wherein the blocks (20) comprise a first type of blocks (20) and a second type of blocks (20) of different chemical nature of the first type of blocks (20).

12. The transfer method according to one of claims 1 to 11, wherein the free surface (40) of the blocks (20) has a square, rectangular, circular or hexagonal shape.

13. The transfer method according to one of claims 1 to 12, wherein the final substrate (60) comprises at least one material comprised in the list: Si, Ge, GaAs, sapphire, alumina, glass, quartz, ceramics, plastic, metal, SiC, AIN.

14. A stack comprising:
a first substrate comprising, on a main face, blocks (20) assembled according to a first main face (30) to the first substrate, said main face of the first substrate being planar when the first substrate is in the free condition, the blocks (20) being in a single-crystal material, and comprising an embrittlement area (50),
the stack being **characterized in that** it comprises a second substrate assembled according to a second main face of the blocks (20) opposite to the first main face (30) of said blocks, the main face of the first substrate being deformed so that the second main faces of the blocks (20) are coplanar.

15. The stack according to claim 14, wherein the second substrate is assembled to the second face of the blocks (20) by molecular adhesion.

16. The stack according to claim 14 or 15, wherein the blocks (20) have a thickness equal to the distance between the first face and the second face of said block (20), the thickness difference between the thinnest block (20) and the thickest block (20) is less than 50 µm, preferably less than 5 µm.

17. The stack according to one of claims 14 to 16, wherein the blocks (20) comprise an embrittlement area (50), the embrittlement area (50) and the second face of each block (20) delimiting a block portion (70) intended to be transferred onto the second substrate, the embrittlement area (50) of each of the blocks (20) being formed by implantation of ionic species.

18. The stack according to one of claims 14 to 17, wherein the blocks (20) comprise at least one material comprised in the list: SiC, GaN, GaAs, InP, GaSb, GaP, InAs, Ge, ZnO, LiTaO₃, LiNbO₃, diamond, sapphire, MgO, CeO₂, YSZ, SrTiO₃, BaTiO₃, LaAlO₃, silicon.

19. The stack according to one of claims 14 to 18, wherein the final substrate (60) comprises at least one material comprised in the list: Si, Ge, GaAs, sapphire, alumina, glass, quartz, ceramics, plastic, metal, SiC, AIN.

20. The stack according to one of claims 14 to 19, wherein the first substrate comprises at least one material comprised in the list: polymer, BCB, PDMS, polyimides, silicone resins, epoxy resins, elastomers, aluminum film, copper film, molybdenum film, tungsten film, nickel film, stainless steel film, glasses, polycrystalline materials, ceramic materials, sintered materials, oxides, aluminas, nitrides, silicates, carbides.
